# EUROPEAN PATENT APPLICATION

(11) **EP 3 629 676 A1**
(43) Date of publication of application: **01.04.2020**
(21) Application number: 18382695.7
(22) Date of filing: 28.09.2018
(51) Int. Cl.: H05B 33/08

(54) **AUTOMOTIVE LIGHTING DEVICE**

(71) Applicant: Valeo Iluminacion, 23600 Martos (ES)
(72) Inventor: SANTAELLA, Juan-Jose, 23600 MARTOS (ES); CALAVIA, Antonio, 23600 MARTOS (ES); COBO, Angel-Jesus, 23600 MARTOS (ES); LOPEZ, Jose-Luis, 23600 MARTOS (ES); ILLAN, Antonio, 23600 MARTOS (ES)
(74) Representative: Valeo Vision

(57) **Abstract**

The invention provides an automotive lighting device (10) for an automotive vehicle (100), the electronic device (10) comprising light sources (1), a current sink device (4) and a light driver (3). The current sink device (4) is in connection with one of the light sources (1), so that each light source with one current sink device forms a light group. The light driver (3) is configured to be electrically fed by the power source (2), the light driver (3) comprising terminals (32) and being configured to selectively activate or deactivate current flow in each terminal (32), in such a way that each light group is connected to one of the terminals. The light driver (3) is located in series with the light groups with respect to the power source (2), either between the power source (2) and the light groups or between the light groups and the ground connection. The current sink device (4) comprises an input (41) configured to receive an activation signal, in such a way that the current sink device (4) is configured to be selectively activated to consume power.

## Description

### TECHNICAL FIELD

This invention is related to the field of automotive lighting devices which are controlled to provide complex lighting functionalities.

### STATE OF THE ART

Automotive lighting devices are designed to perform different functionalities. To do so, the lighting device comprises different lighting modules, each of them being in charge of one of the lighting functionality.

However, in some cases, the device must be simplified, or become smaller. As a consequence, it is sometimes desirable to merge different functionalities in a single lighting module. These functionalities are usually grouped by colour: since the TAIL function and the BRAKE function have the same colour, the same lighting module is designed to perform both functionalities.

In some cases, as the example mentioned above, the different functionalities are defined by different luminous intensities. This is sometimes solved by providing two independent modules: the BRAKE function would activate a more powerful light source and the TAIL function would activate a less powerful light source.

A LED may perform both functionalities just by being fed by different current values, but current light drivers are unable to manage two different current values when these values are very different.

Current solutions involve the use of a PWM signal which feeds the light driver. In this PWM signal, the current amplitude is constant, but the density varies, so that the light intensity of the LEDs is varied. However, this involves the light driver being turned on and off many times per second, and this is harmful both for the light driver itself and for the rest of the elements of the circuits, due to the electromagnetic radiation emitted each time the light driver is turned on. Further, PWM signals require an additional system to generate them.

A better solution is therefore sought to use the same light source to perform different functionalities with different current values.

### DESCRIPTION OF THE INVENTION

The invention provides a solution for this problem by means of a method for manufacturing an automotive prototype part according to claim 1. Preferred embodiments of the invention are defined in dependent claims.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

In a first inventive aspect, the invention provides an automotive lighting device for an automotive vehicle, the automotive lighting device comprising
a plurality of light sources configured to be electrically fed between a power source and a ground connection;
at least one current sink device, each current sink device being in connection with one of the light sources, so that each light source with one current sink device forms a light group;
a light driver configured to be electrically fed by the power source, the light driver comprising terminals and being configured to selectively activate or deactivate current flow in each terminal, in such a way that each light group is connected to one of the terminals; wherein the light driver is located in series with the light groups with respect to the power source, either between the power source and the light groups or between the light groups and the ground connection, and
wherein each current sink device comprises an input configured to receive an activation signal, in such a way that the current sink device is configured to be selectively activated to consume power.

The light driver and the light groups are fed by the power source in series. In some embodiments, the light driver may work as a current sink, where the light groups are located after the power source and the driver is located between the light groups and the ground connection. In other embodiments, the light driver works as a current source, wherein the light driver is located after the power source and the light groups are located between the light driver and the ground connection. In any cases, each light group is connected to the light driver by a terminal of the light driver, which is in charge of controlling the current passing through the corresponding light group.

The advantage of this automotive lighting device is the fact that the current sink device is located to selectively consume power so that the light group is driven by a constant current value regardless the current driven across the light source. As a consequence, the driver may be used to control these light sources, and the light sources are able to provide different functionalities with different current values, without the light driver being affected by these difference of current values.

The drawbacks associated to the use of PWM signals are also avoided: electromagnetic radiation, additional systems to generate the PWM signal, micro-controllers, and so on.

In some particular embodiments, each current sink device is arranged in parallel with one of the light sources, so that each light source in parallel with one current sink device forms a light group.

A parallel arrangement is an optimal solution to provide a current sink which consumes power from the light group. The light group demands a constant current value, but this is divided between the current consumed by the light source and the current consumed by the current sink device. When the maximum current value is required for the light source, the current sink device does not demand any current, and when the lower current value is required for the light source, the current sink device demands the correspondent current value, to keep the current value of the light group the same as in the first case.

In some particular embodiments, the automotive lighting device comprises more than one current sink device, each current sink device being in connection with one of the light sources.

In some cases, more than one light source is needed to perform complex lighting functionalities, for example those which require animations. As a consequence, each light source, or at least some of them, requires a current sink device.

In some particular embodiments, each current sink device comprises
a transistor with an emitter, a base and a collector,
a first resistor stage between the emitter and the terminal, and
a reference system which branches from a point between the base and the terminal.

This arrangement is suitable for activating the current consumption.

In some particular embodiments, the first resistor stage comprises at least two resistors in parallel. Two resistors in parallel are used for a more accurate setting of the current value.

In some particular embodiments, the reference system comprises a linear regulator. A linear regulator is a good option for providing an accurate current value, when a fixed value is required to be consumed by the current sink device.

In some particular embodiments, the linear regulator comprises a Zener diode. Zener diodes are used in linear regulators to achieve an operation which is not affected by temperature variations.

In other particular embodiments, the reference system is connected in series with the light source, so as to form a current mirror. This alternative is used when the current to be consumed by the current sink device is not a fixed value, but depends on the current consumed by the light source.

In some particular embodiments, the light sources are configured to perform more than one different lighting functionality.

In this case, different lighting functionalities may be performed without altering the current crossing the light driver.

In some particular embodiments, the functionalities are daily running light and position light, stop light and tail light or turning indicator.

These functionalities are particularly advantageous for this invention, since they may be grouped and operated with different intensity.

In some particular embodiments, the light sources are solid-state light sources, such as LEDs.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the life span of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figures 1a and 1b show general electric schemes of automotive lighting devices according to the invention.
Figure 2 shows a particular example of a current sink device belonging to an automotive lighting device of the invention.
Figure 3 shows an automotive lighting device according to the invention installed in an automotive vehicle

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

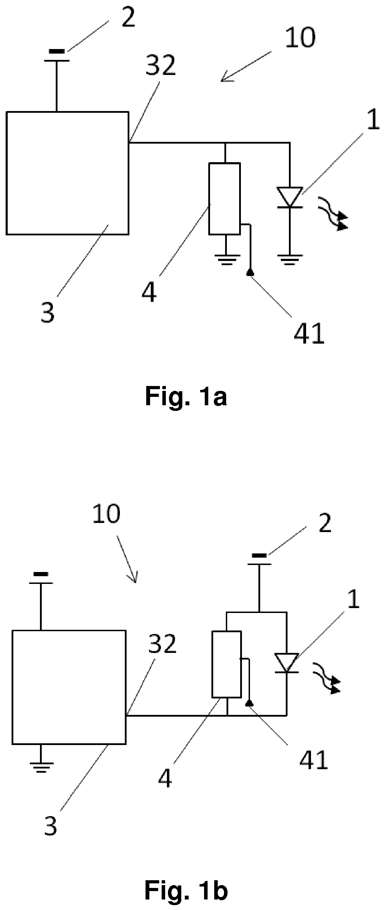

Figures 1a and 1b show general electric schemes of automotive lighting devices 10 according to the invention.

Both automotive lighting devices 10 comprises LEDs 1 powered between a power source 2 and a ground connection. Further, each lighting device 10 comprises a current sink device 4 connected in parallel with each LED 1, forming light groups.

Each automotive lighting device 10 further comprises a light driver 3 configured to be electrically fed by the power source 2, the light driver 3 comprising terminals 32 and being configured to selectively activate or deactivate current flow in each terminal 32, in such a way that each light group is connected to one of the terminals 32.

In Figure 1a, the light driver 3 is arranged in series with the light groups with respect to the power source 2, being located between the power source and the light groups. The current therefore flows from the light driver 3 to the light groups.

In Figure 1b, the light driver 3 is also arranged in series with the light groups with respect to the power source 2, but in this case, the light driver 3 is located between the light groups and the ground connection. In this case, the current flows from the light groups to the light driver.

In both cases, each current sink device 4 comprises an input 41 configured to receive an activation signal, in such a way that the current sink device is configured to be selectively activated to consume power. When the current sink device 4 is activated, it consumes power so that the current is divided between the LED 1 and the current sink device 4, so that the LED 1 may receive different current values without this difference being noticed by the light driver 3.

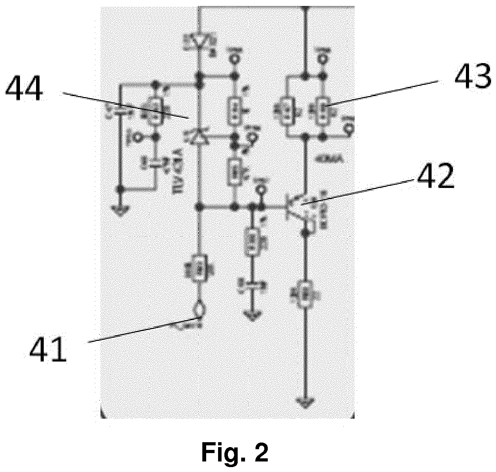

Figure 2 shows a particular example of a current sink device 4 belonging to an automotive lighting device of the invention.

This current sink device 4 comprises
a transistor 42 with an emitter, a base and a collector,
a first resistor stage 43 between the emitter and the terminal, and
a reference system 44 which branches from a point between the base and the terminal.

The first resistor stage 43 comprises two resistors in parallel, to provide a more accurate control of the current value.

In this particular embodiment, the reference system 44 comprises a linear regulator with a Zener diode.

When an activation signal is received in the input 41, due, e.g., to a change in the lighting functionality, the transistor 42 is switched on, so that the current sink device 4 starts consuming a current value which is defined by the voltage which feds the LED 1 and the resistor stage 43. This current value is designed so that the LED 1 may perform two different functions, a first one when receiving the whole current value (current sink deactivated) and a second one when receiving only part of the current value (current sink activated).

In an alternative example of a current sink device belonging to an automotive device of the invention, the reference system is connected in series with the light source, so as to form a current mirror. This causes the current sink device consume a current value which is proportional to the current value consumed by the LED.

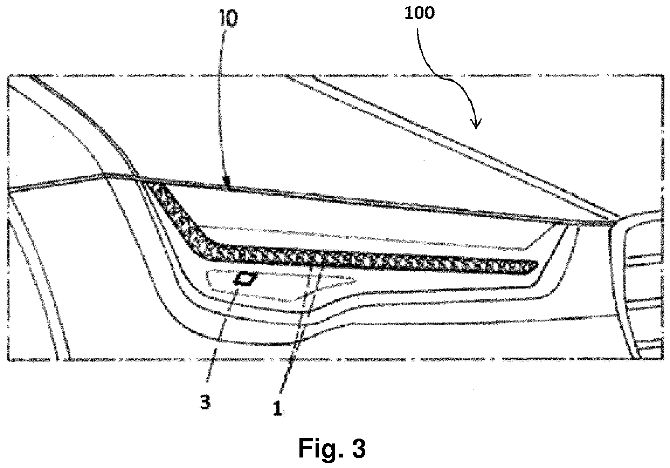

Figure 3 shows an automotive lighting device 10 according to the invention installed in an automotive vehicle 100. In this case, instead of one LED for each light group, there is a plurality of LEDs 1 configured to provide a daily running light and a position light. Depending on the lighting functionality required, the LEDs 1 will be fed with a different intensity, without the driver 3 noticing an important change in the output value.

## Claims

1. Automotive lighting device (10) for an automotive vehicle (100), the automotive lighting device (10) comprising
a plurality of light sources (1) configured to be electrically fed between a power source (2) and a ground connection;
at least one current sink device (4), each current sink device (4) being in connection with one of the light sources (1), so that each light source with one current sink device forms a light group;
a light driver (3) configured to be electrically fed by the power source (2), the light driver (3) comprising terminals (32) and being configured to selectively activate or deactivate current flow in each terminal (32), in such a way that each light group is connected to one of the terminals;
wherein the light driver (3) is located in series with the light groups with respect to the power source, either between the power source and the light groups or between the light groups and the ground connection, and
wherein each current sink device comprises an input configured to receive an activation signal, in such a way that the current sink device is configured to be selectively activated to consume power.

2. Automotive lighting device (10) according to claim 1, wherein each current sink device (4) is arranged in parallel with one of the light sources (1), so that each light source in parallel with one current sink device forms a light group.

3. Automotive lighting device (10) according to any of the preceding claims, comprising more than one current sink device (4), each current sink device (4) being in connection with one of the light sources.

4. Automotive lighting device (10) according to any of the preceding claims, wherein each current sink device (4) comprises
a transistor (42) with an emitter, a base and a collector,
a first resistor stage (43) between the emitter and the terminal, and
a reference system (44) which branches from a point between the base and the terminal.

5. Automotive lighting device (10) according to claim 4, wherein the first resistor stage (43) comprises at least two resistors in parallel.

6. Automotive lighting device (10) according to any of claims 4 or 5 wherein the reference system (44) comprises a linear regulator.

7. Automotive lighting device (10) according to claim 6, wherein the linear regulator comprises a Zener diode.

8. Automotive lighting device (10) according to any of claims 4 or 5 wherein the reference system is connected in series with the light source (1), so as to form a current mirror.

9. Automotive lighting device (10) according to any of the preceding claims, wherein the light sources (1) are configured to perform more than one different lighting functionality.

10. Automotive lighting device (10) according to claim 9, wherein the functionalities are daily running light and position light, stop light and tail light or turning indicator.

11. Automotive lighting device (10) according to any of the preceding claims, wherein the light sources (1) are solid-state light sources, such as LEDs.
